# EUROPEAN PATENT APPLICATION

(11) **EP 0 913 715 A2**
(43) Date of publication of application: **06.05.1999**
(21) Application number: 98120514.9
(22) Date of filing: 29.10.1998
(51) Int. Cl.: G02B 5/02, G02F 1/1335

(54) **Method for producing light control sheet**

(30) Priority: 31.10.1997 JP 300009/97
(71) Applicant: Sumitomo Chemical Company, Limited, Chuo-ku Osaka 541-8550 (JP)
(72) Inventor: Takemura, Shinichi, Hoya-shi, Tokyo (JP); Yasunori, Yukio, Ikeda-shi, Osaka (JP)
(74) Representative: Henkel, Feiler, Hänzel

(57) **Abstract**

The present invention provides a method for producing a light control sheet having a function of scattering an incident light of a particular angle range comprising the steps of:(1)forming a layer comprising photopolymerizable composition on a sheet,(2)curing the layer by irradiation with light from a particular direction,(3)laminating a transparent film on the cured layer to achieve adhesion thereof,(4)irradiating the cured layer with light through the transparent film.

According to the method of the present invention, a light control sheet which provides no sticky feeling, and has a sufficient commercial value, can be producing by means of a relatively simple apparatus with stability.

## Description

The present invention relates to a method for producing a light control sheet having a function of scattering an incident light of particular angle range. More particularly, it relates to a method for producing a light control sheet which provides no sticky feeling of the surface thereof.

The light control sheet is useful as a film for controlling visual angle for privacy protection, enlargement in visual angle of liquid crystal displays, and the like.

As a method for producing such a light control sheet, for example, there is known a method in which a layer comprising a photopolymerizable composition containing at least two kinds of photopolymerizable compounds having mutually different refractive indexes is formed on a sheet, which is then irradiated with light from a particular direction to polymerize and cure the layer( USP 5,108,857).

However, there may occur a sticky feeling in the resulting a light control sheet depending upon the kind of the photopolymerizable composition to be used, resulting in a large reduction in commercial value thereof.

An object of the present invention is to provide a method for producing a light control sheet providing almost no sticky feeling.

That is, the present invention provides a method for producing a light control sheet having a function of scattering an incident light of a particular angle range comprising the steps of:
forming a layer comprising photopolymerizable composition on a sheet,
curing said layer by irradiation with light from a particular direction,
laminating a transparent film on said cured layer to achieve adhesion thereof
irradiating said cured layer with light through said transparent film.

Figure 1 is a schematic sectional view showing a step of irradiating a layer comprising photopolymerizable composition formed on a sheet with light from a particular direction to cure the layer in example.
Figure 2 is a schematic sectional view showing a step of laminated a transparent film on the cured layer to achieve adhesion thereof, followed by light irradiation in example.

In the present invention, the step of forming a layer comprising photopolymerizable compositions on a sheet, followed by light irradiation from a particular direction to cure the layer, resulting in a cured layer is carried out by known methods.

The thickness of the sheet to be used in the present invention is not specifically limited. However, the sheet with a thickness in the range of about 20 *µ*m to 2 cm is generally used, which includes film-like and plate-like ones other than the sheet-like one.

The materials of the sheet are not specifically limited, examples of which are polyethylene terephthalate, acrylic resin, polyolefine such as polyethylene and polypropylene, synthetic resin such as vinyl chloride resin, and glass.

Such sheets may be supplied as belt-like sheet, or one by one. In the case of glass, the sheets of glass are supplied one by one.

As photopolymerizable composition, for example, the photopolymerizable compositions described in USP 5,108,857, JP 03-107901 A, USP 5,112,722, USP 5,137,801 are used. Examples thereof are:
photopolymerizable composition (I): a composition comprising two or more kinds of (A) monomers each having a polymerizable double bond [hereinafter, referred to as compound (A)], and/or (B) oligomers each having a polymerizable double bond [hereinafter, referred to as compound (B)] , the compounds (A) and the compounds (B) having mutually different refractive indexes, respectively,
photopolymerizable composition (II): (C) a monomer having plural polymerizable double bonds, or an oligomer having plural polymerizable double bonds, wherein the refractive indexes before and after curing differ [hereinafter, referred to as compound (C)] ,
photopolymerizable composition (III): a composition comprising a compound (A), a compound (B), or a compound (C), and a compound (D) having a refractive index different from those of these compounds and no photopolymerizability [hereinafter, referred to as compound (D)] .

In the photopolymerizable composition (I) and the photopolymerizable composition (III), preferred are combinations of two or more kinds of the compounds (A) and/or the compounds (B) having mutually different refractive indexes, wherein the refractive indexes differ by 0.01 or more.

In the photopolymerizable composition (II), it is preferable that the refractive indexes before and after curing of the compound (C) differ by 0.01 or more.

Examples of the compound (A) are tetrahydrofurfuryl acrylate, ethylcarbitol acrylate, dicyclopentenyloxyethyl acrylate, phenylcarbitol acrylate, nonylphenoxyethyl acrylate, 2-hydroxy-3-phenoxypropyl acrylate, *ω*-hydroxyhexanoyloxyethyl acrylate, acryloyloxyethyl succinate, acryloyloxyethyl phthalate, tribromophenoxyethyl acrylate, isobornyl acrylate, 2-ethylhexyl acrylate, lauryl acrylate, 2,2,3,3-tetrafluoropropyl acrylate; methacrylates corresponding to these acrylates; N-vinylpyrrolidone, and N-acryloylmorpholine. These monomers can be used in mixture of two or more kinds thereof.

Examples of the compound (B) are polyol polyacrylate, modified polyol polyacrylate, polyacrylate having an isocyanuric acid skeleton, melamine acrylate, polyacrylate having a hydantoin skeleton, polybutadiene acrylate, epoxy acrylate, and urethane acrylate. These oligomers can be used in mixture of two or more kinds thereof.

Examples of the compound (C) are acrylate compounds such as triethylene glycol diacrylate, polyethylene glycol diacrylate, neopentyl glycol diacrylate, 1,6-hexanediol diacrylate, dicyclopentadienyl diacrylate hydride, ethylene oxide modified bisphenol A diacrylate, trimethylol propane triacrylate, pentaerythritol hexaacrylate, trisacryloxy isocyanurate, multifunctional epoxy acrylate, and multifunctional urethane acrylate; methacrylates corresponding to these acrylates; divinylbenzene, triallyl isocyanurate, and diethylene glycol bisallylcarbonate. These compounds may be used alone, or in combination with other compounds.

It is noted that these compounds can be also used as compound (A) or compound (B) if they satisfy the conditions of difference in refractive index.

Examples of the compound (D) are high-molecular compounds such as polystyrene, polymethyl methacrylate, polyethylene oxide, polyvinyl pyrrolidone, polyvinyl alcohol, and polyamide; organic compounds such as toluene, n-hexane, cyclohexane, methyl alcohol, ethyl alcohol, acetone, methyl ethyl ketone, tetrahydrofuran, ethyl acetate, dimethyl formamide, dimethyl acetoamide, acetonitrile, organohalogen compounds, and organosilicon compounds; and plastic additives such as plasticizer and stabilizer.

The photopolymerizable composition of the present invention may contain a photopolymerization initiator for improving the curability. Examples of the photopolymerization initiator are benzophenone, benzyl, Michler's ketone, 2-chlorothioxanthone, 2,4-diethylthioxanthone, benzoin ethyl ether, diethoxyacetophenone, benzyldimethylketal, 2-hydroxy-2-methylpropiophenone, and 1-hydroxycyclohexylphenyl ketone.

A layer comprising such photopolymerizable composition is formed by applying the photopolymerizable composition on a sheet with known methods such as a doctor roll method, gravure roll method, and Meyer bar method.

The thickness of the layer comprising the photopolymerizable composition is not specifically limited, however, it is generally in the range of several tens µm to several hundreds µm, preferably in the range of 50 µm to 500 µm.

Then, the layer comprising the photopolymerizable composition formed on the sheet is irradiated with light from a particular direction. Such a particular direction is a direction within the angle range of an incident light selectively scattering at the light control sheet to be an object. It is noted that this direction varies slightly depending upon the photopolymerizable composition to be used, and the like, and hence the pre-production is conducted to confirm the direction, after which the irradiation is carried out.

The light for irradiation is appropriately selected in accordance with the photopolymerizable compositions to be used. However, ultraviolet light is preferred in view of the easiness of its handling under ordinary illumination light. Therefore, as photopolymerizable composition, the ones which will be cured by ultraviolet light are preferred.

The light irradiation is conducted as follows: for example, a line source or point light source is selected as light source, and a slit, a light-shielding sheet, an interference filter, and the like are disposed between the light source and a layer comprising photopolymerizable composition on a sheet so that only a light in a prescribed direction is irradiated. The shape of the light source, and the positions of the light source and slit, and the light-shielding sheet and the layer comprising photopolymerizable composition on a sheet are appropriately adjusted to adjust the irradiation angle of the light.

The irradiation time and the irradiation energy of the light are appropriately selected in accordance with the composition and the thickness of a layer of the photopolymerizable composition to be used and the like.

In this manner, the layer comprising the photopolymerizable composition is irradiated with light to cure the layer, thereby forming a cured layer.

In the present invention, a transparent film is laminated on this cured layer to achieve adhesion thereof, and the cured layer is irradiated with light through the transparent film.

As transparent film, the one capable of allowing the light to be irradiated subsequently to pass therethrough to a certain degree is used. Examples of the materials for the transparent film in the case where a ultraviolet light is used as light to be irradiated subsequently, are polycarbonate, polyethylene terephthalate, polymethyl methacrylate, polyvinyl chloride, polystyrene, and polyacetyl cellulose. It is noted that the transparent films in the present invention include sheet-like and plate-like ones other than the so-called film-like ones.

The method of adhesion is not specifically limited. It is sufficient as long as there is no layer of air between the cured layer and the transparent film. Generally, the adhesion is conducted by pressing with a roll.

The cured layer to which the transparent film is laminated is irradiated with light through the transparent film.

The light for irradiation is appropriately selected in accordance with the photopolymerizable composition to be used. However, ultraviolet light is preferred in view of the easiness of its handling under ordinary illumination light.

Such a light is generally a diffused light. For irradiation with a diffused light, for example, an irradiated light may be scattered by a transparent film to be laminated. However, the method in which irradiation is conducted by allowing a light to pass through a light-scattering plate such as ground glass can scatter the irradiated light sufficiently, and hence it is preferred.

The irradiation time and the irradiation energy of the light are appropriately selected in accordance with the composition and the thickness of a cured layer, and the like.

It is conceivable that a transparent film is laminated on the cured layer to achieve adhesion thereof, which causes curing in the state where the cured layer cuts the contact with oxygen, and hence the sticky feeling of the resulting light control sheet disappears. If the transparent film is laminated on the layer of the photopolymerizable compositions from the beginning to be irradiated with light from a particular direction, a cured layer having a smooth surface cannot be obtained, thus being undesirable.

Generally, after irradiation, the transparent film laminated is peeled off, resulting in a light control sheet. Also, the resulting laminate can be used as it is as light control sheet without peeling off the transparent film. Alternatively, it is possible to peel off the sheet in which a layer of the photopolymerizable composition is formed to be used.

According to the method of the present invention, a light control sheet which provides no sticky feeling, and has a sufficient commercial value, can be producing by means of a relatively simple apparatus with stability.

### EXAMPLES

The present invention will be explained by the following examples.

The gel content ratio of the cured layer of the light control sheet was measured as follows:

The sample of the cured layer is dipped in methylethylketone, then a soluble component of the sample is extracted under agitation for 24 hours. The gel content ratio is calculated from insoluble residue which is regard as a gel component.

### Comparative Example 1

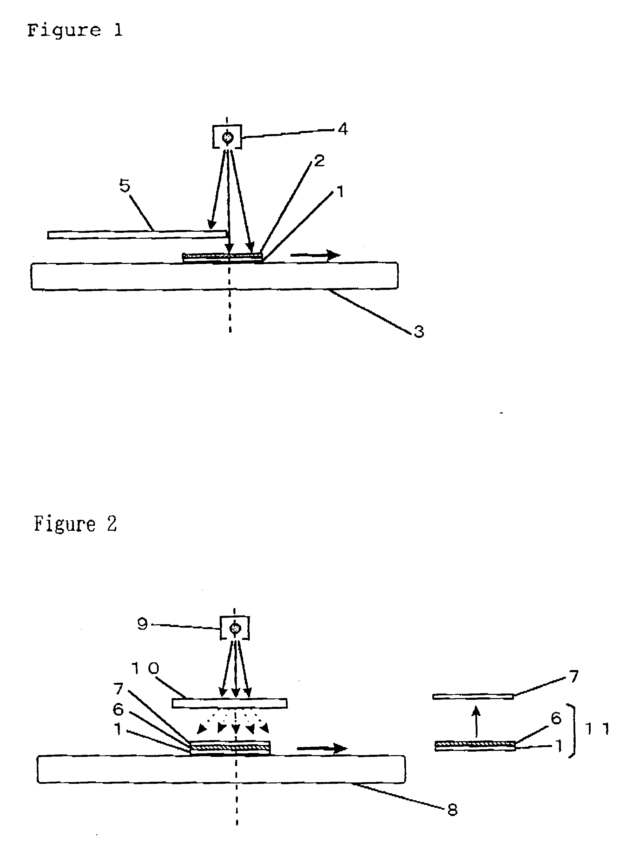

Two moles of polypropylene glycol (average molecular weight 3000), 2.7 moles of hexamethylene diisocyanate, 0.3 moles of tolylene diisocyanate, and 2 moles of 2-hydroxyethyl acrylate are allowed to react to obtain a polyether-urethane acrylate (average molecular weight 6000, refractive index 1.460). Forty parts by weight of the resulting polyether-urethane acrylate is mixed with 30 parts by weight of 2,4,6-tribromophenyl acrylate, 30 parts by weight of 2-hydroxy-3-phenoxypropyl acrylate (refractive index 1.526), and 1.5 parts by weight of a photopolymerization initiator [2-hydroxy-2-methylpropiophenone] to obtain a photopolymerizable composition. The resulting photopolymerizable composition is applied onto a sheet [polyethylene terephthalate film, thickness 188 µm] (1) to form a layer (2) of the photopolymerizable composition (thickness 165 µm), as shown in Figure 1.

Then, the sheet in which this layer is formed is mounted on a conveyor (3) to be moved at a constant speed (1.0 m/minute), during which it is irradiated with a ultraviolet light. A bar-like mercury lamp [80 W/cm] is employed as light source (4) for a ultraviolet light. It is noted that the direction of the length of the bar-shaped mercury lamp is the direction of the normal to the sheet surface in Figure 1. The distance between the bar-shaped mercury lamp (4) and the sheet is taken as 1100 mm. Also, there is placed a light-shielding sheet (5) between the bar-shaped mercury lamp and the sheet. By using this light-shielding sheet, the ultraviolet irradiation initiates on the layer(2) from when the layer(2) comes right under the bar-shaped mercury lamp. As the sheet is mounted on the conveyor to advance with the conveyor, the irradiation angle of a ultraviolet light on one point on the layer varies in accordance with the advancement. The irradiation time of a ultraviolet light on one point on the layer (2) is taken as 9 seconds. Such irradiation causes the layer of the photopolymerizable compositions to be cured, forming a cured layer (6) to obtain a light control sheet. The gel content ratio and the surface state of the cured layer (6)of the resulting light control sheet are shown in table 1.

### Example 1

An experiment is carried out in the same manner as in comparative example 1 to form the cured layer (6) on a sheet. Then, on the cured layer (6), a transparent film [polyethylene terephthalate film, thickness 38 µm] (7) is laminated by a laminator to achieve adhesion thereof, as shown in Figure 2. Then, the resulting laminate is mounted on a conveyor (8) to be moved at a constant speed (1.0 m/minute), during which it is irradiated with a ultraviolet light. A spherical mercury lamp is employed as light source (9) for a ultraviolet light. At this process, there is placed a ground glass (10) between the mercury lamp and the laminate, and a diffused light is adopted as ultraviolet light used for irradiation. The distance between the light source (9) and the sheet (1) is taken as 400 mm, while the distance between the light source (9) and the ground glass (10) is taken as 300 mm. The irradiation time of a ultraviolet light on one point on the cured layer (6) is taken as 13 seconds.

Thereafter, the transparent film (7) is peeled off to obtain a light control sheet (11). The gel content ratio and the surface state of the cured layer (6) of the light control sheet are shown in table 1.

### Comparative Example 2

Two moles of polypropylene glycol (average molecular weight 3000), 2.7 moles of hexamethylene diisocyanate, 0.3 moles of tolylene diisocyanate, and 2 moles of 2-hydroxyethyl acrylate are allowed to react to obtain a polyether-urethane acrylate (average molecular weight 6000, refractive index 1.460). Thirty parts by weight of the resulting polyether-urethane acrylate is mixed with 70 parts by weight of 2-hydroxy-3-phenoxypropyl acrylate (refractive index 1.526), and 1.5 parts by weight of a photopolymerization initiator [2-hydroxy-2-methylpropiophenone] to obtain a photopolymerizable composition.

An experiment is carried out in the same manner as in comparative example 1, except that the photopolymerizable composition obtained as described above is used in place of the photopolymerizable composition obtained in comparative example 1. Thus, a cured layer is formed on a sheet to obtain a light control sheet. The gel content ratio and the surface state of the cured layer of the light control sheet are shown in Table 1.

### Example 2

A cured layer is formed on a sheet in the same manner as in comparative example 2. An experiment is carried out in the same manner as in example 1, except that a transparent film [polyethylene terephthalate film, thickness 38 µm] is laminated on the cured layer by a laminator to achieve adhesion thereof, thereby obtaining a light control sheet. The gel content ratio and the surface state of the cured layer of the light control sheet are shown in Table 1.

### Comparative Example 3

An experiment is carried out in the same manner as in example 1, except that ultraviolet irradiation is conducted without laminating a transparent film [polyethylene terephthalate film, thickness 38 µm] on the cured layer, thereby obtaining a light control sheet. The gel content ratio and the surface state of the cured layer of the light control sheet are shown in Table 1.

### Comparative Example 4

An experiment is carried out in the same manner as in example 2, except that ultraviolet irradiation is conducted without laminating a transparent film [polyethylene terephthalate film, thickness 38 µm] on the cured layer, thereby obtaining a light control sheet. The gel content ratio and the surface state of the cured layer of the light control sheet are shown in Table 1.

**Table 1**

| | Gel content ratio (%) | Surface state |
|---|---|---|
| Comparative example 1 | 68 | Uncured substance adheres to hand |
| Example 1 | 92 | Good |
| Comparative example 2 | 65 | Uncured substance adheres to hand |
| Example 2 | 90 | Good |
| Comparative example 3 | 87 | Uncured substance slightly adheres to hand |
| Comparative example 4 | 83 | Uncured substance slightly adheres to hand |

## Claims

1. A method for producing a light control sheet having a function of scattering an incident light of a particular angle range comprising the steps of:
forming a layer comprising photopolymerizable compositions on a sheet,
curing said layer by irradiation with light from a particular direction,
laminating a transparent film on said cured layer to achieve adhesion thereof,
irradiating said cured layer with light through said transparent film.

2. A method for producing a light control sheet according to claim 1, wherein said photopolymerizable composition are (I) a composition comprising two or more kinds of monomers each having a polymerizable double bond, and/or oligomers each having a polymerizable double bond, said monomers and said oligomers having mutually different refractive indexes, respectively; (II) a monomer having plural polymerizable double bonds, or an oligomer having plural polymerizable double bonds, said monomer or said oligomer being a compound which differs in refractive index between before and after curing; or (III) a composition comprising (i) two or more kinds of monomers each having a polymerizable double bond, said monomers having mutually different refractive indexes, (ii) two or more kinds of oligomers each having a polymerizable double bond, said oligomers having mutually different refractive indexes, or (iii) a monomer having plural polymerizable double bonds, or an oligomer having plural polymerizable double bonds, said monomer or said oligomer being a compound which differs in refractive index between before and after curing, and (iv) a compound having a different refractive index from those of these compounds and no photopolymerizability.

3. A method for producing a light control sheet according to claim 2, wherein the difference in refractive index of two or more kinds of the monomers each having a polymerizable double bond, and/or the oligomers each having a polymerizable double bond, said monomers and said oligomers having mutually different refractive indexes, respectively, is at least 0.01.

4. A method for producing a light control sheet according to claim 1, wherein said particular direction is a direction in the angle range of an incident light scattering at the light control sheet to be an object.

5. A method for producing a light control sheet according to claim 1, wherein both the light to be irradiated from a particular direction and the light to be irradiated after laminating the transparent film are ultraviolet lights.

6. A method for producing a light control sheet according to claim 1, wherein the light to be irradiated after laminating the transparent film is diffused light.
